(19) Europäisches Patentamt
European Patent Office
Office européen des brevets

(11) EP 1 344 222 B1

(12) **EUROPÄISCHE PATENTSCHRIFT**

(45) Veröffentlichungstag und Bekanntmachung des Hinweises auf die Patenterteilung:
**20.10.2004 Patentblatt 2004/43**

(21) Anmeldenummer: **01990313.7**

(22) Anmeldetag: **19.12.2001**

(51) Int Cl.[7]: **G11C 11/22**

(86) Internationale Anmeldenummer:
**PCT/DE2001/004785**

(87) Internationale Veröffentlichungsnummer:
**WO 2002/050842 (27.06.2002 Gazette 2002/26)**

(54) **VERFAHREN ZUM AUSLESEN UND SPEICHERN EINES ZUSTANDES AUS EINEM ODER IN EINEN FERROELEKTRISCHEN TRANSISTOR EINER SPEICHERZELLE UND SPEICHERMATRIX**

METHOD FOR READING OUT OR IN A STATUS FROM OR TO A FERROELECTRICAL TRANSISTOR OF A MEMORY CELL AND MEMORY MATRIX

PROCEDE D'EXTRACTION ET DE MEMORISATION D'UN ETAT DEPUIS OU DANS UN TRANSISTOR FERROELECTRIQUE D'UNE CELLULE DE MEMOIRE ET MATRICE DE MEMOIRE

(84) Benannte Vertragsstaaten:
**DE FR GB IE IT**

(30) Priorität: **21.12.2000 DE 10064031**

(43) Veröffentlichungstag der Anmeldung:
**17.09.2003 Patentblatt 2003/38**

(73) Patentinhaber: **Infineon Technologies AG**
**81669 München (DE)**

(72) Erfinder:
- **GOEBEL, Holger**
  **22043 Hamburg (DE)**
- **HOENIGSCHMID, Heinz**
  **05452 Essex Junction, NY (US)**
- **HOENLEIN, Wolfgang**
  **82008 Unterhaching (DE)**
- **HANEDER, Thomas**
  **85221 Dachau (DE)**
- **ULLMANN, Marc**
  **71155 Altdorf (DE)**

(74) Vertreter: **Dokter, Eric-Michael**
**Anwaltskanzlei,**
**Viering, Jentschura & Partner,**
**Steinsdorfstrasse 6**
**80538 München (DE)**

(56) Entgegenhaltungen:
**US-A- 5 515 311** **US-A- 5 959 879**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft ein Verfahren zum Auslesen und Speichern des Zustands aus einem oder in einen ferroelektrischen Transistor einer Speicherzelle und eine Speichermatrix.

Ein solches Verfahren und eine solche Speichermatrix sind aus [1] bekannt.

Die aus [1] bekannte Speichermatrix ist eine Matrix mit einer Vielzahl von Speicherzellen mit jeweils einem ferroelektrischen Transistor, die in Form einer quadratischen Matrix miteinander verbunden sind. Weiterhin weist die Speichermatrix eine Auslese-/Speicher-Steuervorrichtung auf, mit der ein Zustand eines ferroelektrischen Transistors einer Speicherzelle in der Speichermatrix gespeichert werden kann oder der aktuelle Zustand des entsprechenden ferroelektrischen Transistors der Speicherzelle ausgelesen werden kann.

Gemäß der in [1] beschriebenen Vorgehensweise wird, wenn ein Zustand, in einem ferroelektrischen Transistor einer Speicherzelle der Speichermatrix gespeichert, gelöscht oder gelesen wird, eine entsprechende Auslese-/Speicherspannung an die entsprechenden Wortleitungen bzw. Bitleitungen angelegt. Durch das Anlegen der erforderlichen Auslese-/Speicherspannung werden auch in der Speichermatrix benachbart liegende weitere ferroelektrische Transistoren, die mit dem ferroelektrischen Transistor, dessen Zustand gespeichert oder ausgelesen werden soll, verbunden sind, beeinflusst. Auf diese Weise kann es passieren, dass durch das Auslesen oder Speichern eines Zustands eines ferroelektrischen Transistors der Speichermatrix ein Zustand eines weiteren ferroelektrischen Transistors der Speichermatrix fehlerhaft, das heißt ungewollt verändert wird.

Wie in [1] beschrieben ist, liegt eine Auslese-/Schreibspannung von $V_{pp}/V_{rr}$ an dem ferroelektrischen Transistor, aus dem bzw. in den ein Zustand ausgelesen bzw. gespeichert werden soll, an. In diesem Fall liegt an den mit diesem ferroelektrischen Transistor verbundenen benachbarten weiteren ferroelektrischen Transistoren eine Störspannung von ungefähr $\pm V_{pp}/2$ oder $\pm V_{pp}/3$ an, durch die der Zustand des entsprechenden weiteren ferroelektrischen Transistors fehlerhaft verändert werden kann.

Diese Problematik wird anhand von **Fig.2** im weiteren erläutert.

In **Fig.2** ist ein Diagramm 200 mit einem Verlauf der ferroelektrischen Polarisation 201 im Gate eines ferroelektrischen Transistors in Abhängigkeit von einer angelegten Gate-Spannung $V_{GS}$ 202 dargestellt. In dem Diagramm 200 ist die Gate-Spannung 202 in Volt ([V]) und die ferroelektrische Polarisation 201 in Coulomb/m$^2$ ([C/m$^2$]) angegeben.

Der Verlauf der ferroelektrischen Polarisation 201 abhängig von der Gate-Spannung $V_{GS}$ 202 wird durch eine Hystereseschleife 203 beschrieben. Wie **Fig.2** zu entnehmen ist, weist ein üblicher ferroelektrische Transistor zwei stabile Polarisationszustände, einen ersten stabilen Polarisationszustand 204 und einen zweiten stabilen Polarisationszustand 205 auf. Durch Ändern der angelegten Gate-Spannung $V_{GS}$, insbesondere durch eine oben beschriebene "Störspannung" von $V_{pp}/2$ oder $V_{pp}/3$ kann der Zustand des ferroelektrischen Transistors entlang der Hystereseschleife 203 übergehen in elektrisch nicht-unterscheidbare Polarisationszustände, nämlich in einen ersten nicht-unterscheidbaren Polarisationszustand 206 und in einen zweiten nicht-unterscheidbaren Polarisationszustand 207.

Während es in einfacher Weise möglich ist, den ersten unterscheidbaren Polarisationszustand 204 elektrisch von dem zweiten unterscheidbaren Polarisationszustand 205 zu unterscheiden, womit zwei unterschiedliche Zustände durch den ferroelektrischen Transistor innerhalb der Speichermatrix realisiert und erkannt werden können, ist eine solche elektrische Unterscheidbarkeit bei den nicht-unterscheidbaren Polarisationszuständen 206, 207 nicht gewährleistet.

Somit kann durch eine solche Störspannung der in benachbarten weiteren ferroelektrischen Transistoren in der Speichermatrix gespeicherte Zustand verändert werden oder zumindest undefiniert werden, das heißt es wird ein Polarisationszustand in dem entsprechenden benachbarten ferroelektrischen Transistor gebildet, der nicht verlässlich ausgelesen, das heißt elektrisch unterschieden werden kann.

Ein weiterer ferroelektrischer Transistor und ein Verfahren zu dessen Herstellung sind in [2] beschrieben.

In [3] ist ein ferroelektrischer DRAM-Speicher beschrieben, wobei jede Speicherzelle einen ferroelektrischen Feldeffekttransistor als deren jeweiliges Speicherelement aufweist. Ferner enthält der ferroelektrische DRAM-Speicher einen mit den Speicherzellen gekoppelten Lese- und Refresh-Schaltkreis zum Lesen der in den jeweiligen Speicherzellen gespeicherten Daten, mittels Erfassen der Source-/Drain-Leitfähigkeit des jeweiligen ferroelektrischen Feldeffekttransistors, und zum Auffrischen der in den ferroelektrischen Feldeffekttransistoren gespeicherten Daten.

Somit liegt der Erfindung das Problem zugrunde, einen Zustand aus einem ferroelektrischen Transistor auszulesen oder einen Zustand in einem ferroelektrischen Transistor einer Speicherzelle zu speichern, welche Speicherzelle in einer Speichermatrix mit mehreren weiteren Speicherzellen mit weiteren ferroelektrischen Transistoren angeordnet ist, wobei vermieden werden soll, dass die weiteren ferroelektrischen Transistoren in weiteren Speicherzellen der Speichermatrix durch das Auslesen oder Speichern eines ferroelektrischen Transistors in einen nicht-unterscheidbaren Polarisationszustand überführt werden.

Das Problem wird durch das Verfahren zum Auslesen oder Speichern eines Zustands aus einem oder in einen ferroelektrischen Transistor einer Speicherzelle sowie durch eine Speichermatrix mit den Merkmalen gemäß den unabhängigen Patentansprüchen gelöst.

Bei einem Verfahren zum Auslesen oder Speichern eines Zustands aus einem oder in einen ferroelektrischen Transistor einer Speicherzelle, die in einer Speichermatrix mit mehreren weiteren Speicherzellen mit weiteren ferroelektrischen Transistoren angeordnet ist, wird der Zustand aus dem ferroelektrischen Transistor ausgelesen oder in den ferroelektrischen Transistor gespeichert. Mindestens ein weiterer ferroelektrischer Transistor wird während des Auslesens oder Speicherns des Zustands derart angesteuert, dass der weitere ferroelektrische Transistor in dessen Verarmungsbereich betrieben wird.

Eine Speichermatrix weist mehrere miteinander verbundene Speicherzellen auf, wobei zumindest ein Teil der Speicherzellen mindestens einen ferroelektrischen Transistor aufweist. Weiterhin ist in der Speichermatrix eine Auslese-/Speicher-Steuervorrichtung vorgesehen, mit der ein Auslesen oder ein Speichern eines Zustands aus einem oder in einem ferroelektrischen Transistor einer Speicherzelle der Speichermatrix gesteuert wird. Die Auslese-/Speicher-Steuervorrichtung ist derart eingerichtet, dass der Zustand aus dem ferroelektrischen Transistor ausgelesen wird oder in den ferroelektrischen Transistor gespeichert wird. Die Auslese-/Speicher-Steuervorrichtung ist weiterhin derart eingerichtet, dass mindestens ein weiterer ferroelektrischer Transistor in der Speichermatrix während des Auslesens oder des Speicherns des Zustands derart angesteuert wird, dass der weitere ferroelektrische Transistor in dessen Verarmungsbereich betrieben wird.

Anschaulich kann die Erfindung darin gesehen werden, dass erkannt wurde, dass zum Programmieren eines ferroelektrischen Transistors in einer Speicherzelle dieser in dessen Inversionsbereich gebracht werden muss. Ein benachbarter ferroelektrischer Transistor einer benachbarten Speicherzelle sollte jedoch nicht unbeabsichtigt programmiert werden, so dass gewährleistet sein sollte, dass diese nicht in ihren jeweiligen Inversionsbereich gebracht werden. Dies wird gewährleistet, indem erfindungsgemäß zumindest ein weiterer ferroelektrischer Transistor in der Speichermatrix oder alle weiteren ferroelektrischen Transistoren in der Speichermatrix während des Auslesens oder Speicherns eines Zustands aus oder in den ferroelektrischen Transistor in ihrem jeweiligen Verarmungsbereich betrieben werden.

Durch die Erfindung wird es verglichen mit dem Stand der Technik erstmals möglich, dass das Programmierschema der ferroelektrischen Transistoren in der Speichermatrix die Gate-Bulk-Spannung (im Weiteren auch als Gate-Substrat-Spannung bezeichnet) der weiteren ferroelektrischen Transistoren nicht auf $V_{pp/2}$ oder $V_{pp/3}$ beschränkt, wie dies bei dem Programmierschema aus [1] erforderlich ist.

Damit kann entgegen der in [1] beschriebenen Vorgehensweise das Bulk-Potential bei den weiteren ferroelektrischen Transistoren in der Speichermatrix konstant gehalten werden.

Da das gesamte Bulk-Material in diesem Fall erfindungsgemäß nicht umgeladen werden muss, verringert sich sowohl die für das Programmieren erforderliche elektrische Ladung als auch die für das Programmieren eines ferroelektrischen Transistors in einer Speichermatrix erforderliche Zeit in erheblichem Maße.

Anschaulich wurde somit erfindungsgemäß erkannt, dass durch geeignete Wahl der Gate-Source-Spannung, die an die weiteren ferroelektrischen Transistoren angelegt wird während des Auslesens oder Speicherns eines Zustands aus oder in einen ferroelektrischen Transistor, das Disturb-Verhalten eines aus ferroelektrischen Transistoren aufgebauten Speichers maßgeblich beeinflusst wird.

Bevorzugte Weiterbildungen der Erfindung ergeben sich aus den abhängigen Ansprüchen.

Die im weiteren beschriebenen Ausgestaltungen betreffen sowohl das Verfahren als auch die Ausgestaltung der Auslese-/Speicher-Steuervorrichtung, wobei gemäß der entsprechenden Weiterbildung jeweils die Auslese-/Speicher-Steuervorrichtung derart eingerichtet ist, dass die entsprechende Weiterbildung realisiert ist.

Die entsprechende Ausgestaltung der Auslese-/Speicher-Steuervorrichtung kann mittels eines Computerprogramms, das in einem Speicher der Auslese-/Speicher-Steuervorrichtung vorgesehen ist und mittels eines Prozessors ausgeführt wird, in Software realisiert sein oder mittels einer elektronischen Spezialschaltung in Hardware.

In einer bevorzugten Ausgestaltung der Erfindung ist es vorgesehen, dass der Zustand aus dem ferroelektrischen Transistor ausgelesen oder in den ferroelektrischen Transistor gespeichert wird, indem eine Auslese-/Speicherspannung an die Gate-Elektrode des ferroelektrischen Transistors angelegt wird zum Auslesen oder Speichern des Zustands.

In einer Speicherzelle der Speichermatrix können mehrere Transistoren, insbesondere mehrere ferroelektrische Transistoren, eingesetzt werden.

Auch wenn im weiteren Ausführungsbeispiel ein ferroelektrischer Transistor eingesetzt wird, der gemäß einem bestimmten Verfahren hergestellt worden ist, so kann jedoch in einer alternativen Ausführungsform ein beliebiger weiterer ferroelektrischer Transistor im Rahmen der Erfindung eingesetzt werden.

So können insbesondere unterschiedliche Materialien für die dielektrische Zwischenschicht, insbesondere einer Dicke zwischen ungefähr 3 nm und 25 nm) des ferroelektrischen Transistors verwendet werden, die beispielsweise Ceoxid $CeO_2$, Hafniumoxid $HfO_2$, Praseodymoxid $Pr_2O_3$, Zirkonoxid $ZrO_2$, Titanoxid $TiO_2$, Tantaloxid $TaO_2$ oder Dialuminiumtrioxid $AlO_2O_3$ aufweisen.

Als ferroelektrische Schicht kann beispielsweise BMF ($BaMgF_4$), PZT ($(PbZr)TiO_3$) oder SBT ($SrBi_2Ta_2O_9$) verwendet werden. Die ferroelektrische Schicht weist eine Dicke zwischen ungefähr 30 nm und 300 nm auf.

Weiterhin kann die Erfindung auch im Rahmen eines p-Kanal ferroelektrischen Transistors eingesetzt werden, auch wenn im weiteren Ausführungsbeispiel die Erfindung anschaulich anhand eines n-Kanal ferroelektrischen Transistors beschrieben wird. In diesem Fall ist lediglich eine Umpolung der entsprechend anzulegenden Spannungen vorzunehmen.

Auch können mehrere elektrische Zwischenschichten innerhalb eines ferroelektrischen Transistors vorgesehen sein, die ein oder mehrere der oben beschriebenen Materialien aufweisen.

Allgemein kann für die elektrische Zwischenschicht des ferroelektrischen Transistors ein beliebiger Isolator mit möglichst großer Dielektrizitätskonstante und einem hohen Bandabstand verwendet werden.

Die ferroelektrische Schicht kann auch direkt auf dem Substrat abgeschieden werden, wenn die Bildung störender Zwischenschichten vermieden werden kann, beispielsweise durch epitaktisches Wachstum der ferroelektrischen Schicht.

Es ist in diesem Zusammenhang anzumerken, dass die Erfindung nicht auf die Struktur des in dem Ausführungsbeispiel beschriebenen ferroelektrischen Transistor beschränkt ist, sondern dass auch beispielsweise die in [1] oder [2] beschriebene Struktur eines ferroelektrischen Transistors im Rahmen der Erfindung ohne weiteres verwendet werden kann.

Der weitere ferroelektrische Transistor oder mehrere weitere ferroelektrische Transistoren in der Speichermatrix können während des Auslesens oder Speicherns des Zustands aus dem ferroelektrischen Transistor oder in den ferroelektrischen Transistor in deren Verarmungsbereichen betrieben werden, indem die weiteren ferroelektrischen Transistoren derart angesteuert werden, dass die an den weiteren ferroelektrischen Transistoren anliegenden Gate-Source-Spannungen kleiner sind als deren jeweilige Schwellenspannung.

Diese Ansteuerung des oder der weiteren ferroelektrischen Transistoren ist sehr einfach und somit sehr kostengünstig möglich, ohne dass die ferroelektrischen Transistoren selbst in ihren dauerhaften Eigenschaften verändert werden müssen.

Der oder die weiteren ferroelektrischen Transistoren können ferner im jeweiligen Verarmungsbereich betrieben werden, in dem der oder die weiteren ferroelektrischen Transistoren derart angesteuert werden, dass gilt

$$V_{FB} - F(P_{FE}) \leq V_{GS} \leq V_{th} - F(P_{FE}),$$

wobei mit

- $V_{FB}$ die Flachbandspannung des weiteren ferroelektrischen Transistors,
- $V_{GS}$ die Gate-Source-Spannung des weiteren ferroelektrischen Transistors,
- $V_{th}$ die Schwellenspannung des weiteren ferroelektrischen Transistors,
- $F(P_{FE})$ eine Funktion der ferroelektrischen Polarisation $P_{FE}$ des weiteren ferroelektrischen Transistors

bezeichnet wird.

Gemäß einer anderen Weiterbildung der Erfindung werden der oder die weiteren ferroelektrischen Transistoren derart angesteuert, dass bei dem jeweiligen weiteren ferroelektrischen Transistor die angelegte Gate-Spannung gleich ist der jeweils angelegten Source-Spannung und der angelegten Drain-Spannung.

Auf diese Weise wird gewährleistet, dass die Gate-Source-Spannung des jeweiligen weiteren ferroelektrischen Transistors gleich ist der Gate-Drain-Spannung des weiteren ferroelektrischen Transistors, nämlich den Wert 0 Volt aufweist, was bedeutet, dass die Gate-Source-Spannung, die an dem jeweiligen weiteren ferroelektrischen Transistor anliegt, immer kleiner ist als dessen Schwellenspannung.

Ein Ausführungsbeispiel der Erfindung ist in den Figuren dargestellt und wird im weiteren näher erläutert:

Es zeigen:

| | |
|---|---|
| Figuren 1a bis 1d | eine Speichermatrix mit vier Speicherzellen mit jeweils einem ferroelektrischen Transistor (Figur 1a), einen Spannungsverlauf einer an das Gate einer ausgewählten Speicherzelle angelegten elektrischen Spannung (Figur 1b), einen Spannungsverlauf einer an die Source einer ausgewählten Speicherzelle angelegten elektrischen Spannung (Figur 1c) und ein Diagramm, in dem der Verlauf der Polarisation des ausgewählten ferroelektrischen Transistors abhängig von der an diesen angelegten Gate-Bulk-Spannung dargestellt ist; |
| Figur 2 | ein Diagramm, in dem der Verlauf der ferroelektrischen Polarisation im Gate eines üblichen ferroelektrischen Transistors in Abhängigkeit der anliegenden Gate-Spannung beim Auslesen oder Speichern eines Zustands aus oder in den ferroelektrischen Transistor gemäß dem Stand der Technik dargestellt ist; |

| | |
|---|---|
| Figur 3 | eine Skizze eines ferroelektrischen Transistors gemäß einem Ausführungsbeispiel der Erfindung; |
| Figur 4 | ein Ablaufdiagramm, in dem die einzelnen Schritte zum Auslesen bzw. Speichern eines Zustands aus bzw. in einen ferroelektrischen Transistor gemäß einem Ausführungsbeispiel der Erfindung dargestellt ist; |
| Figur 5 | ein Diagramm, in dem der Verlauf der Gate-Ladung abhängig von der an einem ferroelektrischen Transistor anliegenden Gate-Bulk-Spannung dargestellt ist; und |
| Figuren 6a bis 6c | einen Spannungsverlauf einer an das Gate einer weiteren, nicht ausgewählten Speicherzelle angelegten elektrischen Spannung (Figur 6a), einen Spannungsverlauf einer an die Source der weiteren, nicht ausgewählten Speicherzelle angelegten elektrischen Spannung (Figur 6b) und ein Diagramm, in dem der Verlauf der Polarisation des nichtausgewählten ferroelektrischen Transistors abhängig von der an diesen angelegten Gate-Bulk-Spannung dargestellt ist. |

**Fig.1a** zeigt eine Speichermatrix 100 mit vier Speicherzellen 101, 102, 103, 104.

Jede Speicherzelle 101, 102, 103, 104 weist einen ferroelektrischen Transistor 105, 106, 107, 108 auf.

Weiterhin weist die Speichermatrix 100 eine erste Wortleitung 109 und eine zweite Wortleitung 110 auf.

Weiterhin weist die Speichermatrix 100 eine erste Bitleitung 111, eine zweite Bitleitung 112, eine dritte Bitleitung 113 und eine vierte Bitleitung 114 auf.

Das Gate 115 des ersten ferroelektrischen Transistors 105 sowie das Gate 116 des zweiten ferroelektrischen Transistors 106 sind mit der ersten Wortleitung 109 gekoppelt.

Das Gate 117 des dritten ferroelektrischen Transistors 107 und das Gate 118 des vierten ferroelektrischen Transistors 108 sind mit der zweiten Wortleitung 110 gekoppelt.

Die Source 119 des ersten ferroelektrischen Transistors 105 und die Source 120 des dritten ferroelektrischen Transistors 107 sind mit der ersten Bitleitung 111 gekoppelt.

Die Drain 121 des ersten ferroelektrischen Transistors 105 und die Drain 122 des dritten ferroelektrischen Transistors 107 sind mit der zweiten Bitleitung 112 verbunden.

Die Source 123 des zweiten ferroelektrischen Transistors 106 und die Source 124 des vierten ferroelektrischen Transistors 108 sind mit der dritten Bitleitung 113 verbunden.

Die Drain 125 des zweiten ferroelektrischen Transistors 106 und die Drain 126 des vierten ferroelektrischen Transistors 108 sind mit der vierten Bitleitung 114 verbunden.

Die Wortleitungen 109, 110 sowie die Bitleitungen 111, 112, 113, 114 sind mit einer Auslese-/Speicher-Steuervorrichtung 127 verbunden.

Ferner sind die Bulk-Anschlüsse 128, 129 des ersten ferroelektrischen Transistors 105 und des zweiten ferroelektrischen Transistors 106 miteinander über eine weitere elektrische Leitung 132 gekoppelt.

Weiterhin sind die Bulk-Anschlüsse 130, 131 des dritten ferroelektrischen Transistors 107 und des vierten ferroelektrischen Transistors 108 miteinander über eine weitere elektrische Leitung 133 gekoppelt.

Das Speichern eines Zustandes eines ferroelektrischen Transistors in der Speichermatrix 100 sowie das Auslesen eines Zustandes eines ferroelektrischen Transistors in der Speichermatrix 100 wird von der Auslese-/Speicher-Steuervorrichtung 127 durch Anlegen verschiedener Spannungen an die entsprechenden Wortleitungen 109, 110 und/oder an die entsprechenden Bitleitungen 111, 112, 113, 114 gesteuert, wie im weiteren näher erläutert wird.

**Fig.3** zeigt einen ferroelektrischen Transistor 300, wie er als erster ferroelektrischer Transistor 105, als zweiter ferroelektrischer Transistor 106, als dritter ferroelektrischer Transistor 107 und als vierter ferroelektrischer Transistor 108 in der Speichermatrix 100 vorgesehen ist.

Der ferroelektrische Transistor 300 weist ein p-dotiertes Substrat 301 aus Silizium auf, sowie einen Source-Bereich 302 und einen Drain-Bereich 303, denen angrenzend zwei Siliziumoxid-Bereiche 304, 305 angeordnet sind. Diese Bereiche werden mit einem üblichen CVD-Verfahren abgeschieden. Anschließend wird eine dielektrische Zwischenschicht 306 über dem Kanalbereich 307 zwischen dem Source-Bereich 302 und dem Drain-Bereich 303 des ferroelektrischen Transistors 300 aus Siliziumoxid abgeschieden. Die dielektrische Zwischenschicht 306 kann alternativ auch ein anderes Dielektrikum aufweisen, beispielsweise $Al_2O_3$, $CeO_2$, $ZrO_2$, $HfO_2$, oder $Pr_2O_3$, das beispielsweise mit Hilfe eines CVD-Verfahrens aufgebracht wird.

Dann wird darauf beispielsweise mit Hilfe eines CVD-Verfahrens eine ferroelektrische Schicht 308 aufgebracht, die SBT ($SrBi_2Ta_2O_9$) oder PZT ($(Pb,Zr)TiO_3$) enthalten kann.

Die Temperung dieser beiden Schichten 306, 308 zur Einstellung der gewünschten Schichteigenschaften kann der Reihe nach, also nach der Abscheidung jeder einzelnen Schicht erfolgen, sie kann aber auch - falls dies gewünscht ist - in einem Schritt nach der Abscheidung beider Schichten 306, 308 erfolgen.

Die dielektrische Zwischenschicht 306 und die ferroelektrische Schicht 308 werden anschließend durch einen Ätzprozess strukturiert.

Wird eine metallische Gate-Elektrode 309 verwendet, so wird diese durch ein Sputter-Verfahren erzeugt und anschließend durch einen Ätzprozess strukturiert.

Die metallische Elektrode kann als Hartmaske zur Strukturierung der darunter liegenden Schichten verwendet werden.

Die Implantation des Source-Bereichs 302 und des Drain-Bereichs 303 kann selbstjustiert zum Gate-Stack erfolgen.

Die restlichen Prozessschritte vor und nach der Herstellung des ferroelektrischen Gate-Stacks können analog zu Standard-CMOS-Fertigungsverfahren erfolgen.

Ferner weist der ferroelektrische Transistor 300 Kontakte 310, 311, 312 auf, die entsprechend mit der Source 302, der Drain 303 und der Gate-Elektrode 309 leitend verbunden sind.

Weiterhin weist der ferroelektrische Transistor 300 eine Silizium-Planarisierungsschicht 313 auf.

Im Weiteren wird anhand von **Fig.4** und den **Fig.1b, Fig.1c** und **Fig.1d** das Auslesen und Speichern eines Zustands in den ersten ferroelektrischen Transistor 105 näher erläutert.

In einem ersten Schritt (Schritt 401) wird zum Speichern eines ersten Zustands eine Speicherspannung $V_{pp}$, die gemäß dem Ausführungsbeispiel $V_{pp}$ = 5V beträgt, an die erste Wortleitung 109 angelegt.

Über dem Gate der jeweiligen weiteren ferroelektrischen Transistoren 106, 107, 108 wird eine Gate-Source-Spannung angelegt, wie im Weiteren näher erläutert.

Anders ausgedrückt bedeutet dies, dass die im Weiteren näher erläuterte Gate-Spannung an die nicht selektierte zweite Wortleitung 110 sowie eine Source-Spannung an die nicht selektierte dritte Bit-Leitung 113 und eine im Weiteren näher erläuterte Drain-Spannung an die nicht selektierte vierte Bit-Leitung 114 angelegt wird.

**Fig.1b** zeigt in einem ersten Spannungs-Diagramm 140 einen Spannungsverlauf 141 einer an die erste Wortleitung 109 angelegten elektrischen Spannung 142 abhängig von der Zeit t 143 in Sekunden.

Insbesondere ist in dem ersten Spannungs-Diagramm 140 ein Programmierbereich 144 dargestellt, während dem der erste ferroelektrische Transistor 105 programmiert wird, das heißt von einem Anfangszustand "0" in einen Endzustand "1" umprogrammiert wird durch Anlegen einer elektrischen Spannung $V_{pp}$ = 5V.

Wie in dem **Fig.1b** zugehörigen zweiten Spannungs-Diagramm 150 (vgl. **Fig.1c**) dargestellt ist, wird während der Programmierung des ersten ferroelektrischen Transistors 105 an die erste Bit-Leitung 111 und an die zweite Bit-Leitung 112 eine Spannung von 0 Volt angelegt, wie an dem Spannungssignalverlauf 151 des zweiten Spannungs-Diagramms 150, in dem die an der ersten Bit-Leitung 111 und der zweiten Bit-Leitung 112 jeweils anliegende elektrische Spannung 152 abhängig von der Zeit t 153 in Sekunden dargestellt ist, zu erkennen ist.

**Fig.1d** zeigt den Polarisationsverlauf 163 des ausgewählten ersten ferroelektrischen Transistors 105 in einem Polarisationsdiagramm 160, in dem die Polarisation 161 in $\mu C/cm^2$ abhängig von der anliegenden Gate-Substrat-Spannung $V_{GB}$ 162 in Volt dargestellt ist.

**Fig.1d** zeigt, dass von dem Anfangszustand "0" 164 durch Anlegen der elektrischen Spannung $V_{pp}$ = 5V an die erste Wortleitung 109 der erste ferroelektrische Transistor 105 in den Endzustand "1" 165 entlang der Hysteresekurve 166 gemäß dem durch Pfeile 167 symbolisierten Verlauf übergeht.

**Fig.1d** zeigt ferner in der Hystereseschleife 166 zwei Plateaubereiche, einen ersten Plateaubereich 168 und einen zweiten Plateaubereich 169, die zumindest teilweise im Wesentlichen parallel zueinander verlaufen, jedoch entlang der Gate-Substrat-Spannung 162 zueinander relativ verschoben sind und ferner jeweils eine unterschiedliche Polarisation aufweisen, wodurch die Unterscheidung der beiden Zustände 164, 165 erst ermöglicht wird.

Anders ausgedrückt bedeutet dies, dass der erste ferroelektrische Feldeffekttransistor 105 durch das Anlagen einer Spannungsdifferenz zwischen dem Gate und dem Substratanschluss des ersten ferroelektrischen Transistors 105 programmiert wird.

Bei einer geeigneten Dotierung des Substrats sowie einer geeigneten Gateoxid-Kapazität des ersten ferroelektrischen Transistors 105 ist die Steigung der Gate-Ladungs-Kurve 501, wie sie beispielhaft in einem Ladungsdiagramm 500 in **Fig.5** dargestellt ist, in dessen Inversionsbereich wesentlich größer als in dessen Verarmungsbereich.

**Fig.5** zeigt den Verlauf der Gate-Ladung $Q_g$ 502 abhängig von der anliegenden Gate-Substrat-Spannung $V_{GB}$ 503 und den Gate-Ladungs-Verlauf 501, der in drei Bereiche 504, 505, 506 eingeteilt werden kann.

Ein erster Bereich 504 wird als Akkumulationsbereich bezeichnet, ein zweiter Bereich 505 stellt den Verarmungsbereich des ferroelektrischen Transistors dar und ein dritter Bereich 506 dessen Inversionsbereich.

Zum Programmieren eines ferroelektrischen Transistors, der eine Speicherzelle bildet, wird der ferroelektrische Transistor in dessen Inversionsbereich 506 gebracht.

Um einen zu dem ferroelektrischen Transistor bena.chbarten ferroelektrischen Transistor nicht ebenfalls unerwünscht zu programmieren, ist erfindungsgemäß zu gewährleisten, dass dieser nicht in seinen jeweiligen Inversionsbereich 506 gebracht wird.

Dies wird, wie im Weiteren näher erläutert, durch die geeignete Wahl einer Gate-Source-Spannung $V_{GS}$, gewährleistet, wobei die Gate-Source-Spannung $V_{GS}$ an die nicht selektierten Zellen, das heißt die weiteren ferroelektrischen Transistoren 106, 107, 108 angelegt werden, derart, dass diese kleiner ist als die von der jeweiligen Polarisation des ferroelektrischen Transistors abhängigen Schwellenspannung $V_{th}$, das heißt es gilt

$$V_{GS} - V_{th} + F(P_{FE}) \leq 0, \quad (1)$$

wobei mit $F(P_{FE})$ eine Funktion der ferroelektrischen Polarisation $P_{FE}$ des weiteren ferroelektrischen Transistors bezeichnet wird.

In **Fig.4** ist der Schritt des Programmierens des ersten ferroelektrischen Transistors 105 in einem weiteren Block 402 symbolisch dargestellt.

Im Wesentlichen zur gleichen Zeit wird an die dritte Bit-Leitung 113 und die vierte Bit-Leitung 114 jeweils eine elektrische Spannung des gleichen Werts der Speicherspannung 141 angelegt, wie dies in **Fig.6b** in dem Diagramm 610 dargestellt ist, in dem ein Spannungsverlauf 611 der an die dritte Bit-Leitung 113 und die vierte Bit-Leitung 114 jeweils angelegten elektrischen Spannung 612 abhängig von der Zeit 613 in Sekunden dargestellt ist.

Zur Verdeutlichung dieser Ansteuerung ist in **Fig.6a** erneut in einem weiteren Diagramm 600 die an der ersten Wortleitung 109 angelegte elektrische Spannung 601 abhängig von der Zeit 602 in einem Spannungsverlauf 603 dargestellt.

Es ist zu bemerken, dass gemäß diesem Ausführungsbeispiel die in dem Programmierbereich 604 an der ersten Wortleitung 109 angelegte elektrische Spannung den gleichen Wert aufweist wie die elektrische Spannung, welche an die dritte Bit-Leitung 113 und an die vierte Bit-Leitung 114 jeweils angelegt werden.

**Fig.6c** zeigt in einem weiteren Polarisationsdiagramm 620 den Verlauf der Polarisation 621 des zweiten ferroelektrischen Transistors 106 bei Programmierung des ersten ferroelektrischen Transistors 105 wie in **Fig.1b** bis **Fig. 1d** dargestellt ist, abhängig von der Gate-Substrat-Spannung $V_{GB}$ 622.

Wie dem weiteren Polarisationsdiagramm 620 zu entnehmen ist, wird die Verbreiterung des zweiten Plateaubereichs 623 erreicht durch das geeignete Anlegen der Gate-Source-Spannung, speziell durch die Wahl der jeweils anzulegenden Drain-Spannung und Source-Spannung an die weiteren ferroelektrischen Transistoren 106, 107, 108 abhängig von der jeweiligen Programmierspannung und somit abhängig von der jeweiligen an dem Gate anliegenden elektrischen Spannung.

Durch die Verbreiterung des zweiten Plateaubereichs 623 wird eine Veränderung des Zustands der weiteren ferroelektrischen Transistoren 106, 107, 108 vermieden.

Wie **Fig.6c** zu entnehmen ist, geht der zweite ferroelektrische Transistor 106 nicht von seinem Anfangszustand 624 "0" in einen Endzustand "1" 625 über, da er entlang der Hystereseschleife 626 nicht den Plateaubereich 623 überwinden kann, wie durch die Pfeile 627 in **Fig.6c** symbolisiert ist.

In diesem Zusammenhang ist zu bemerken, dass gemäß diesem Ausführungsbeispiel sowohl das Gate-Potential als auch das Substrat-Potential fest vorgegeben sind.

Die beiden wählbaren Spannungen an den Source- und Drain-Kontakten der weiteren ferroelektrischen Transistoren 106, 107, werden derart angesteuert, dass gilt, dass die Source-Spannung $V_S$ gleich ist der angelegten Drain-Spannung $V_D$ und der jeweiligen angelegten Gate-Spannung $V_G$, so dass gilt

$$V_{GS} = V_{GD} = 0, \quad (2)$$

und damit

$$V_{GS} = V_{GD} \leq V_{th} - F(P_{FE}). \quad (3)$$

Aufgrund der Matrix-Anordnung aus **Fig.1** liegt an dem ferroelektrischen Transistor 108 die Gate-Spannung $V_G = 0$, eine Source-Spannung und eine Drain-Spannung von beispielsweise $V_S = V_D = 5$ V sowie eine Bulk-Spannung (Substrat-Spannung) $V_B = 0$ V an. Auch diese Spannungen verändern den Zustand der ferroelektrischen Polarisation nicht.

Wenn für den ferroelektrischen Transistor 108 gilt:

$$V_{GB} \leq V_{th} - V_{BS} - F(P_{FE}), \quad (4)$$

so befindet sich auch der ferroelektrische Transistor 108 in Inversion bzw. eventuell in Akkumulation.

Es sollte gewährleistet sein, dass

1. der n-Kanal ferroelektrische Transistor nicht in die Inversion gelangt, und

2. durch die Bulk-Source-Spannung $V_{BS}$ der ferroelektrische Transistor nicht tiefer in die Akkumulation gerät als für den Fall, dass gilt $V_{BS} = 0$.

Auf diese Weise wird gewährleistet, dass der jeweilige weitere ferroelektrische Transistor 106, 107, 108, der auf die oben beschriebene Weise angesteuert wird, in dessen Verarmungsbereich 505 und nicht in dessen Inversionsbereich 506 betrieben wird, so dass eine unerwünschte Umprogrammierung des jeweils weiteren ferroelektrischen Transistors 106, 107, vermieden wird.

Dies wird insbesondere dann sehr einfach zu gewährleisten, wenn der jeweilige ferroelektrische Transistor eine hinreichend klein gewählte Steigung der Gate-Ladungs-Kurve 501 in dessen Verarmungsbereich 505 aufweist.

Allgemein wird ein ferroelektrischer Transistor und damit die weiteren ferroelektrischen Transistoren 106, 107, 108 beim Auslesen des ersten ferroelektrischen Transistors 105 in deren Verarmungsbereich 505 betrieben, wenn für die Gate-Source-Spannung $V_{GS}$ des jeweils weiteren ferroelektrischen Transistors 106, 107, 108 gilt:

$$V_{FB} - F(P_{FE}) \leq V_{GS} \leq V_{th} - F(P_{FE}), \qquad (5)$$

wobei mit

- $V_{FB}$ die Flachbandspannung des weiteren ferroelektrischen Transistors,
- $V_{GS}$ die Gate-Source-Spannung des weiteren ferroelektrischen Transistors,
- $V_{th}$ die Schwellenspannung des weiteren ferroelektrischen Transistors,
- $F(P_{FE})$ eine Funktion der ferroelektrischen Polarisation $P_{FE}$ des weiteren ferroelektrischen Transistors

bezeichnet wird.

Gemäß diesem Ausführungsbeispiel wird die Schwellenspannung $V_{th}$ gemäß folgender Vorschrift angegeben:

$$V_{th} = V_{FB} + 2\Phi_F + \gamma\sqrt{2\Phi_F + U_{SB}}, \qquad (6)$$

mit

$$\gamma = \frac{1}{C'_{Stack}} \sqrt{qN_A 2\varepsilon_0\varepsilon_{Si}}, \qquad (7)$$

wobei mit $\gamma$ der Substratsteuerfaktor bezeichnet wird und

$$\Phi_F = \frac{kT}{q} \ln \frac{N_A}{n_i}, \qquad (8)$$

wobei mit $\Phi_F$ das Fermi-Potential bezeichnet wird und mit $C'_{Stack}$ die Gate-Stack-Kapazität des jeweiligen weiteren ferroelektrischen Transistors 106, 107, 108.

Gemäß dem Ausführungsbeispiel wurden für die in den obigen Vorschriften vorhandenen Parameter die in der folgenden Tabelle aufgeführten Parameterwerte verwendet:

| Parameter | Wert | Einheit |
|---|---|---|
| $P_S$ | 0.1 | $\mu C/cm^2$ |
| $P_r$ | 0.08 | $\mu C/cm^2$ |
| Ec | 30 | kV/cm |
| $t_{fe}$ | 180 | nm |

(fortgesetzt)

| Parameter | Wert | Einheit |
|---|---|---|
| $t_{ox}$ | 20 | NM |
| $\varepsilon_f$ | 250 | |
| $\varepsilon_{ox}$ | 11.7 | |
| A | $2*10^4$ | $\mu m^2$ |
| $N_A$ | $2*10^{15}$ | $cm^{-3}$ |
| $V_{FB}$ | 0 | V |
| $V_D$ | 0.3 | V |
| $V_S$ | 0 | V |
| $V_B$ | 0 | V |

Im weiteren werden einige Alternativen zu dem oben dargestellten Ausführungsbeispiel näher erläutert.

Die Erfindung ist nicht auf in die oben beschriebene konkrete Form einer Speichermatrix, insbesondere nicht auf eine vier Speicherzellen aufweisende Speichermatrix beschränkt. Die Erfindung kann im Rahmen einer beliebig ausgestalteten Speichermatrix mit einer beliebigen Anzahl von Speicherzellen, das heißt von ferroelektrischen Transistoren als Speicherzellen, verwendet werden.

Es ist in diesem Zusammenhang anzumerken, dass das oben beschriebene erfindungsgemäße Programmierschema auch auf eine oder mehrere ausgewählte Speicherzellen angewendet werden kann, deren Zustand nicht verändert werden soll..

Beispielsweise können alle Speicherzellen zu Beginn des Programmierschemas mit dem logischen Wert "0" initialisiert sein. Soll in eine selektierte Speicherzelle ($V_G$ = High für diese Speicherzelle) ein logischer Wert "0" gespeichert werden, d.h. geschrieben werden, so wird ihr Zustand nicht verändert.

Um dies zu gewährleisten werden folgenden Spannungen an die jeweilige Speicherzelle, deren Zustand nicht verändert werden soll, angelegt:

$$V_G = V_S = V_D = \text{High}. \qquad (9)$$

In diesem Fall erfolgt somit kein Umprogrammieren des Zustands der ausgewählten Speicherzelle.

Weiterhin kann eine Speicherzelle auch mehrere Transistoren, insbesondere mehrere ferroelektrische Transistoren aufweisen.

In diesem Dokument sind folgende Veröffentlichungen zitiert:

[1] T. Nakamura et al, A Single-Transistor Ferroelectric Memory Cell, IEEE International Solid-State Circuits Conference, ISSCC95, Session 4, Technology Directions: Displays, Photonics and Ferroelectric Memories, S. 68 - 69, 1995

[2] Jong-Son Lyu et al, Metal-Ferroelectric-Semiconductor Field-Effect Transistor (MFSFET) for Single Transistor Memory by Using Poly-Si Source/Drain and $BaMgF_4$ Dielectric, IEDM 1996, S. 503 - 506, 1996

[3] US 6,067,244

**Bezugszeichenliste**

100 Speichermatrix
101 Speicherzelle
102 Speicherzelle
103 Speicherzelle
104 Speicherzelle

105 Erster ferroelektrischer Transistor
106 Zweiter ferroelektrischer Transistor
107 Dritter ferroelektrischer Transistor
108 Vierter ferroelektrischer Transistor
109 Erste Wortleitung
110 Zweite Wortleitung
111 Erste Bitleitung
112 Zweite Bitleitung
113 Dritte Bitleitung
114 Vierte Bitleitung
115 Gate erster ferroelektrischer Transistor
116 Gate zweiter ferroelektrischer Transistor
117 Gate dritter ferroelektrischer Transistor
118 Gate vierter ferroelektrischer Transistor
119 Source erster ferroelektrischer Transistor
120 Source dritter ferroelektrischer Transistor
121 Drain erster ferroelektrischer Transistor
122 Drain dritter ferroelektrischer Transistor
123 Source zweiter ferroelektrischer Transistor
124 Source vierter ferroelektrischer Transistor
125 Drain zweiter ferroelektrischer Transistor
126 Drain vierter ferroelektrischer Transistor
127 Auslese-/Speicher-Steuervorrichtung
128 Bulk-Anschluss erster ferroelektrischer Transistor
129 Bulk-Anschluss zweiter ferroelektrischer Transistor
130 Bulk-Anschluss dritter ferroelektrischer Transistor
131 Bulk-Anschluss vierter ferroelektrischer Transistor
132 Elektrische Leitung
133 Elektrische Leitung
140 Erstes Spannungs-Diagramm
141 Spannungsverlauf
142 Elektrische Spannung
143 Zeit
144 Programmierbereich
150 Zweites Spannungs-Diagramm
151 Spannungsverlauf
152 Elektrische Spannung
153 Zeit
160 Polarisationsdiagramm
161 Polarisation
162 Gate-Substrat-Spannung
163 Polarisationsverlauf
164 Anfangszustand
165 Endzustand
166 Hysteresekurve
167 Pfeile
168 Erster Plateaubereich
169 Zweiter Plateaubereich

200 Verlauf ferroelektrische Polarisation im Gate eines ferroelektrischen Transistors in Abhängigkeit der Gate-Spannung
201 Ferroelektrische Polarisation im Gate eines ferroelektrischen Transistors
202 Gate-Spannung
203 Hysterese-Schleife
204 Erster unterscheidbarer Polarisationszustand
205 Zweiter unterscheidbarer Polarisationszustand
206 Erster nicht-unterscheidbarer Polarisationszustand
207 Zweiter nicht-unterscheidbarer Polarisationszustand

300 Ferroelektrischer Transistor
301 Substrat
302 Source-Bereich
303 Drain-Bereich
304 Siliziumoxid-Bereich
305 Siliziumoxid-Bereich
306 Dielektrische Zwischenschicht
307 Kanalbereich
308 Ferroelektrische Schicht
309 Metallische Gate-Elektrode
310 Kontakt
311 Kontakt
312 Kontakt
313 Schutzschicht

401 Anlegen Speicherspannung an die erste Wortleitung
402 Anlegen Speicherspannung an die erste Wortleitung
403 Anlegen Drain-Spannungen und Source-Spannungen an die weiteren ferroelektrischen Transistoren

500 Ladungsdiagramm
501 Gate-Ladungs-Kurve
502 Gate-Ladung
503 Gate-Substrat-Spannung
504 Akkumulationsbereich ferroelektrischer Transistor
505 Verarmungsbereich ferroelektrischer Transistor
506 Inversionsbereich ferroelektrischer Transistor

600 Diagramm
601 Elektrische Spannung
602 Zeit
603 Spannungsverlauf
604 Programmierbereich
610 Diagramm
611 Spannungsverlauf
612 Elektrische Spannung
613 Zeit

620 Polarisationsdiagramm
621 Polarisation
622 Gate-Substrat-Spannung
623 Zweiter Plateaubereich
624 Anfangszustand
625 Endzustand
626 Hystereseschleife
627 Pfeil

**Patentansprüche**

**1.** Verfahren zum Auslesen oder Speichern eines Zustands aus einem oder in einen ferroelektrischen Transistor (105) einer Speicherzelle (101), die in einer Speichermatrix (100) mit mehreren weiteren Speicherzellen (102, 103, 104) mit weiteren ferroelektrischen Transistoren (106, 107, 108) angeordnet ist,

- bei dem der Zustand aus dem ferroelektrischen Transistor (105) ausgelesen wird oder in den ferroelektrischen Transistor (105) gespeichert wird,
- das Verfahren **dadurch gekennzeichnet daß**, mindestens ein weiterer ferroelektrischer Transistor (106, 107, 108) in der Speichermatrix (100) während des Auslesens oder Speicherns des Zustands derart angesteuert wird, dass er in dessen Verarmungsbereich betrieben wird.

**2.** Verfahren nach Anspruch 1,
bei dem der Zustand aus dem ferroelektrischen Transistor (105) ausgelesen oder in den ferroelektrischen Transistor (105) gespeichert wird, indem eine Auslese-/Speicherspannung an die Gateelektrode (115) des ferroelektrischen Transistors (105) angelegt wird zum Auslesen oder Speichern des Zustands.

**3.** Verfahren nach Anspruch 1 oder 2,
bei dem der weitere ferroelektrische Transistor (106, 107, 108) im Verarmungsbereich betrieben wird, indem der weitere ferroelektrische Transistor (106, 107, 108) derart angesteuert wird, dass die an dem weiteren ferroelektrischen Transistor (106, 107, 108) anliegende Gate-Source Spannung kleiner ist als dessen Schwellenspannung abzüglich eines von der ferroelektrischen Polarisation abhängigen Terms.

**4.** Verfahren nach Anspruch 1 oder 2,
bei dem der weitere ferroelektrische Transistor (106, 107, 108) im Verarmungsbereich betrieben wird, indem der weitere ferroelektrische Transistor (106, 107, 108) derart angesteuert wird, dass gilt:

$$V_{FB} - F(P_{FE}) \leq V_{GS} \leq V_{th} - F(P_{FE}),$$

wobei mit

- $V_{FB}$ die Flachbandspannung des weiteren ferroelektrischen Transistors (106, 107, 108),
- $V_{GS}$ die Gate-Source-Spannung des weiteren ferroelektrischen Transistors (106, 107, 108),
- $V_{th}$ die Schwellenspannung des weiteren ferroelektrischen Transistors (106, 107, 108),
- $F(P_{FE})$ einer Funktion der ferroelektrischen Polarisation $P_{FE}$ des weiteren ferroelektrischen Transistors (106, 107, 108) bezeichnet wird.

**5.** Verfahren nach einem der Ansprüche 1 bis 4,
bei dem der weitere ferroelektrische Transistor (106, 107, 108) im Verarmungsbereich betrieben wird, indem der weitere ferroelektrische Transistor (106, 107, 108) derart angesteuert wird, dass die an den weiteren ferroelektrischen Transistor (106, 107, 108) angelegte Gate-Spannung gleich ist der an den weiteren ferroelektrischen Transistor (106, 107, 108) angelegten Source-Spannung und der an den weiteren ferroelektrischen Transistor (106, 107, 108) angelegten Drain-Spannung.

**6.** Verfahren nach einem der Ansprüche 1 bis 5,
bei dem in mindestens einer'Speicherzelle (101, 102, 103, 104) der Speichermatrix (100) mehrere Transistoren verwendet werden.

**7.** Speichermatrix (100) mit

- mehreren miteinander verbundenen Speicherzellen (101, 102, 103, 104), wobei zumindest ein Teil der Speicherzellen (101) mindestens einen ferroelektrischen Transistor (105) aufweist,
- einer Auslese-/Speicher-Steuervorrichtung, mit der ein Auslesen oder ein Speichern eines Zustands aus einem oder in einen ferroelektrischen Transistor (105) einer Speicherzelle der Speichermatrix (100) gesteuert wird,
- wobei die Auslese-/Speicher-Steuervorrichtung derart eingerichtet ist, dass der Zustand aus dem ferroelektrischen Transistor (105) ausgelesen wird oder in dem ferroelektrischen Transistor (105) gespeichert wird;

**dadurch gekennzeichnet**

- **dass** mindestens ein weiterer ferroelektrischer Transistor (106, 107, 108) in der Speichermatrix (100) während des Auslesens oder Speicherns des Zustands derart angesteuert wird, dass er in dessen Verarmungsbereich betrieben wird.

**8.** Speichermatrix (100) nach Anspruch 7,
bei der die Auslese-/Speicher-Steuervorrichtung derart eingerichtet ist, dass eine Auslese-/Speicherspannung an die Gateelektrode (115) des ferroelektrischen Transistors (105) angelegt wird zum Auslesen oder Speichern des Zustands.

**9.** Speichermatrix (100) nach Anspruch 7 oder 8,
bei der die Auslese-/Speicher-Steuervorrichtung derart eingerichtet ist, dass der weitere ferroelektrische Transistor (106, 107, 108) derart angesteuert wird, dass die an dem weiteren ferroelektrischen Transistor (106, 107, 108) anliegende Gate-Source Spannung kleiner ist als dessen Schwellenspannung abzüglich eines von der ferroelektrischen Polarisation abhängigen Terms.

**10.** Speichermatrix (100) nach einem der Ansprüche 7 bis 9, bei der mindestens eine Speicherzelle der Speichermatrix (100) mehrere Transistoren aufweist.

**11.** Speichermatrix (100) nach Anspruch 9 oder 10,
bei der die Auslese-/Speicher-Steuervorrichtung derart eingerichtet ist, dass der weitere ferroelektrische Transistor (106, 107, 108) derart angesteuert wird, dass gilt:

$$V_{FB} - F(P_{FE}) \leq V_{GS} \leq V_{th} - F(P_{FE}),$$

wobei mit

- $V_{FB}$ die Flachbandspannung des weiteren ferroelektrischen Transistors (106, 107, 108),
- $V_{GS}$ die Gate-Source-Spannung des weiteren ferroelektrischen Transistors (106, 107, 108),
- $V_{th}$ die Schwellenspannung des weiteren ferroelektrischen Transistors (106, 107, 108),
- $F(P_{FE})$ einer Funktion der ferroelektrischen Polarisation $P_{FE}$ des weiteren ferroelektrischen Transistors (106, 107, 108)

bezeichnet wird.

**12.** Speichermatrix (100) nach einem der Ansprüche 7 bis 11, bei der die Auslese-/Speicher-Steuervorrichtung derart eingerichtet ist, dass der weitere ferroelektrische Transistor (106, 107, 108) derart angesteuert wird, dass die an den weiteren ferroelektrischen Transistor (106, 107, 108) angelegte Gate-Spannung gleich ist der an den weiteren ferroelektrischen Transistor (106, 107, 108) angelegten Source-Spannung und der an den weiteren ferroelektrischen Transistor (106, 107, 108) angelegten Drain-Spannung.

## Claims

**1.** Method for reading out or storing a state from or in a ferroelectric transistor (105) of a memory cell (101) which is arranged in a memory matrix (100) with a plurality of further memory cells (102, 103, 104) with further ferroelectric transistors (106, 107, 108),

- in which the state is read out from the ferroelectric transistor (105) or is stored in the ferroelectric transistor (105);

the method **characterized by**

- driving at least one further ferroelectric transistor (106, 107, 108) in the memory matrix (100) during the read-out or storage of the state in such a way that it is operated in its depletion region.

**2.** Method according to Claim 1, in which the state is readout from the ferroelectric transistor (105) or stored in the ferroetectric transistor (105) by a read-out/storage voltage being applied to the gate electrode (115) of the ferroelectric transistor (105), for the purpose of reading out or storing the state.

**3.** Method according to Claim 1 or 2, in which the further ferroelectric transistor (106, 107, 108) is operated in the depletion region by the further ferroelectric transistor (106, 107, 108) being driven in such a way that the gate-source voltage present at the further ferroelectric transistor (106, 107, 108) is less than the threshold voltage of the said transistor minus a term which is dependent on the ferroelectric polarization.

**4.** Method according to Claim 1 or 2, in which the further ferroelectric transistor (106, 107, 108) is operated in the depletion region by the further ferroelectric transistor (106, 107, 108) being driven in such a way that the following

holds true:

$$V_{FB} - F(P_{FE}) < V_{GS} < V_{th} - F(P_{FE}),$$

where

- $V_{FB}$ designates the flat-band voltage of the further ferroelectric transistor (106, 107, 108),
- $V_{GS}$ designates the gate-source voltage of the further ferroelectric transistor (106, 107, 108),
- $V_{th}$ designates the threshold voltage of the further ferroelectric transistors (106, 107, 108),
- $F(P_{FE})$ designates a function of the ferroelectric polarization $P_{FE}$ of the further ferroelectric transistor (106, 107, 108).

**5.** Method according to one of Claims 1 to 4, in which the further ferroelectric transistor (106, 107, 108) is operated in the depletion region by the further ferroelectric transistor (106, 107, 108) being driven in such a way that the gate voltage applied to the further ferroelectric transistor (106, 107, 108) is equal to the source voltage applied to the further ferroelectric transistor (106, 107, 108) and the drain voltage applied to the further ferroelectric transistor (106, 107, 108).

**6.** Method according to one of Claims 1 to 5, in which a plurality of transistors are used in at least one memory cell (101, 102, 103, 104) of the memory matrix (100).

**7.** Memory matrix (100) having

- a plurality of memory cells (101, 102, 103, 104) connected to one another, at least some of the memory cells (101) having at least one ferroelectric transistor (105),
- a read-out/storage control device, which controls a read-out or storage of a state from or in a ferroelectric transistor (105) of a memory cell of the memory matrix (100),
- the read-out/storage control device being set up in such a way that the state is read out from the ferroelectric transistor (105) or is stored in the ferroelectric transistor (105);

**characterized in**

- **that** at least one further ferroelectric transistor (106, 107, 108) in the memory matrix (100) is driven during the read-out or storage of the state in such a way that it is operated in its depletion region.

**8.** Memory matrix (100) according to Claim 7,
in which the read-out/storage control device is set up in such a way that a read-out/storage voltage is applied to the gate electrode (115) of the ferroelectric transistor (105), for the purpose of reading out or storing the state.

**9.** Memory matrix (100) according to Claim 7, or 8, in which the read-out/storage control device is set up in such a way that the further ferroelectric transistor (106, 107, 108) is driven in such a way that the gate-source voltage present at the further ferroelectric transistor (106, 107, 108) is less than the threshold voltage of the said transistor minus a term which is dependent on the ferroelectric polarization.

**10.** Memory matrix (100) according to one of Claims 7 to 9, in which at least one memory cell of the memory matrix (100) has a plurality of transistors.

**11.** Memory matrix (100) according to Claim 9 or 10, in which the read-out/storage control device is set up in such a way that the further ferroelectric transistor (106, 107, 108) is driven in such a way so that the following holds true:

$$V_{FB} - F(P_{FE}) < V_{GS} < V_{th} - F(P_{FE}), \text{ where}$$

- $V_{FB}$ designates the flat-band voltage of the further ferroelectric transistors (106, 107, 108),
- $V_{GS}$ designates the gate-source voltage of the further ferroelectric transistors (106, 107, 108),
- $V_{th}$ designates the threshold voltage of the further ferroelectric transistors (106, 107, 108),
- $F(P_{FE})$ designates a function of the ferroelectric polarization $P_{FE}$ of the further ferroelectric transistor.

12. Memory matrix (100) according to one of Claims 7 to 11, in which the read-out/storage control device is set up in such a way that the further ferroelectric transistor (106, 107, 108) is driven in such a way so that the gate voltage applied to the further ferroelectric transistor (106, 107, 108) is equal to the source voltage applied to the further ferroelectric transistor (106, 107, 108) and the drain voltage applied to the further ferroelectric transistor (106, 107, 108).

**Revendications**

1. Procédé d'extraction et de mémorisation d'un état depuis ou dans un transistor ferroélectrique (105) d'une cellule de mémoire (101) disposée dans une matrice de mémoire (100) avec plusieurs autres cellules de mémoire (102, 103, 104) et avec d'autres transistors ferroélectriques (106, 107, 108), ledit procédé permettant l'extraction de l'état depuis ledit transistor ferroélectrique (105) ou la mémorisation dudit état dans le transistor ferroélectrique (105); procédé **caractérisé en ce qu'**un autre transistor ferroélectrique (106, 107, 108) au moins est attaqué dans la matrice de mémoire (100) durant l'extraction ou la mémorisation de l'état de telle sorte que ledit transistor fonctionne sa zone de déplétion.

2. Procédé selon la revendication 1 permettant l'extraction de l'état depuis le transistor ferroélectrique (105) ou la mémorisation dudit état dans le transistor ferroélectrique (105), dans lequel une tension d'extraction / de mémorisation est appliquée à l'électrode de grille (115) du transistor ferroélectrique (105) en vue de l'extraction ou de la mémorisation de l'état.

3. Procédé selon la revendication 1 ou 2 permettant le fonctionnement de l'autre transistor ferroélectrique (106, 107, 108) en zone de déplétion, dans lequel cet autre transistor ferroélectrique (106, 107, 108) est attaqué de telle sorte que la tension de source grille appliquée à cet autre transistor ferroélectrique (106, 107, 108) est plus petite que sa tension de seuil, déduction faite d'un facteur dépendant de la polarisation ferroélectrique.

4. Procédé selon la revendication 1 ou 2, permettant le fonctionnement de l'autre transistor ferroélectrique (106, 107, 108) en zone de déplétion, dans lequel que cet autre transistor ferroélectrique (106, 107, 108) est attaqué de telle sorte que l'équation suivante est vérifiée :

$$V_{FB} - F(P_{FE}) \leq V_{GS} \leq V_{th} - F\,(P_{FE})$$

dans laquelle :

$V_{FB}$ est la tension de vallée de l'autre transistor ferroélectrique (106, 107, 108),
$V_{GS}$ est la tension de source grille de l'autre transistor ferroélectrique (106, 107, 108),
$V_{th}$ est la tension de seuil de l'autre transistor ferroélectrique (106, 107, 108),
$F(P_{FE})$ est une fonction de la polarisation ferroélectrique $P_{FE}$ de l'autre transistor ferroélectrique (106, 107, 108).

5. Procédé selon l'une quelconque des revendications 1 à 4, permettant le fonctionnement de l'autre transistor ferroélectrique (106, 107, 108) en mode de déplétion, dans lequel cet autre transistor ferroélectrique (106, 107, 108) est attaqué de telle sorte que la tension de pont appliquée à cet autre transistor ferroélectrique (106, 107, 108) est la même que la tension de source appliquée à cet autre transistor ferroélectrique (106, 107, 108) et la même que la tension de drain appliquée à cet autre transistor ferroélectrique (106, 107, 108).

6. Procédé selon l'une quelconque des revendications 1 à 5, permettant l'utilisation de plusieurs transistors dans une cellule de mémoire au moins (101, 102, 103, 104) de la matrice de mémoire (100).

7. Matrice de mémoire (100) avec

- plusieurs cellules de mémoire (101, 102, 103, 104) reliées entre elles, une partie des cellules de mémoire (101) au moins comportant un transistor ferroélectrique (105) au moins,
- un dispositif de commande d'extraction / de mémorisation avec lequel on commande une extraction ou une mémorisation d'un état depuis ou dans un transistor ferroélectrique (105) d'une cellule de mémoire de la matrice de mémoire (100),

- le dispositif de commande d'extraction / de mémorisation étant disposé de telle sorte que l'état est extrait du transistor ferroélectrique (105) ou mémorisé dans ledit transistor ferroélectrique (105) ;

**caractérisée en ce que**

- un autre transistor ferroélectrique (106, 107, 108) au moins est attaqué dans la matrice de mémoire (100) durant l'extraction ou la mémorisation de l'état, de telle sorte qu'il fonctionne en mode de déplétion.

**8.** Matrice de mémoire (100) selon la revendication 7, dans laquelle le dispositif de commande d'extraction / de mémorisation est installé de telle sorte qu'une tension d'extraction / de mémorisation est appliquée à l'électrode de grille (115) du transistor ferroélectrique (105) en vue de l'extraction ou de la mémorisation de l'état.

**9.** Matrice de mémoire (100) selon la revendication 7 ou 8, dans laquelle le dispositif de commande d'extraction / de mémorisation est installé de telle sorte que l'autre transistor ferroélectrique (106, 107, 108) est attaqué de sorte que la tension de source grille appliquée à cet autre transistor ferroélectrique (106, 107, 108) est plus petite que sa tension de seuil, déduction faite d'un facteur dépendant de la polarisation ferroélectrique.

**10.** Matrice de mémoire (100) selon l'une quelconque des revendications 7 à 9, dans laquelle une cellule de mémoire au moins de la matrice de mémoire (100) comporte plusieurs transistors.

**11.** Matrice de mémoire (100) selon la revendication 9 ou 10, dans laquelle le dispositif de commande d'extraction / de mémorisation est installé de telle sorte que l'autre transistor ferroélectrique (106, 107, 108) est attaqué de sorte que l'équation suivante est valable :

$$V_{FB} - F(P_{FE}) \leq V_{GS} \leq V_{th} - F\,(P_{FE})$$

dans laquelle :

$V_{FB}$ est la tension de vallée de l'autre transistor ferroélectrique (106, 107, 108),
$V_{GS}$ est la tension de source grille de l'autre transistor ferroélectrique (106, 107, 108),
$V_{th}$ est la tension de seuil de l'autre transistor ferroélectrique (106, 107, 108),
$F(P_{FE})$ est une fonction de la polarisation ferroélectrique $P_{FE}$ de l'autre transistor ferroélectrique (106, 107, 108).

**12.** Matrice de mémoire (100) selon l'une quelconque des revendications 7 à 11, dans laquelle le dispositif de commande d'extraction / de mémorisation est installé de telle sorte que l'autre transistor ferroélectrique (106, 107, 108) est attaqué de sorte que la tension de grille appliquée à l'autre transistor ferroélectrique (106, 107, 108) est la même que la tension de source appliquée à cet autre transistor ferroélectrique (106, 107, 108) et la même que la tension de drain appliquée audit autre transistor ferroélectrique (106, 107, 108).

FIG 1A

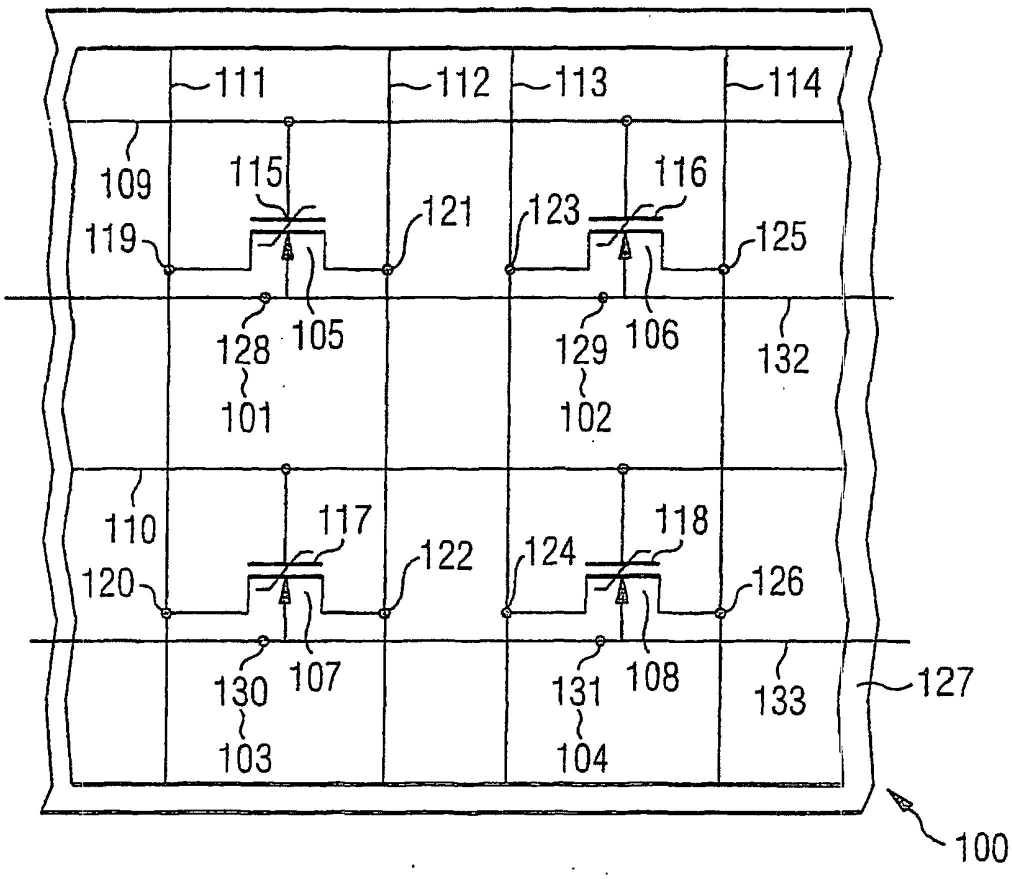
111
112
113
114
109
115
116
119
121
123
125
128
105
129
106
132
101
102
110
117
118
120
122
124
126
130
107
131
108
133
127
103
104
100

FIG 1B

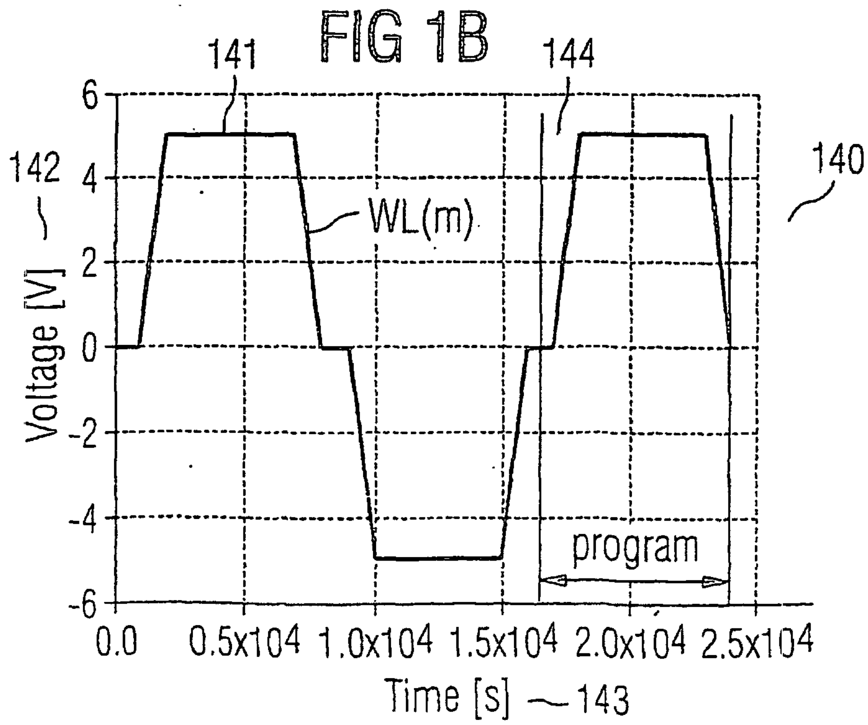
141
144
142
140
Voltage [V]
6
4
2
0
-2
-4
-6
WL(m)
program
0.0
0.5x104
1.0x104
1.5x104
2.0x104
2.5x104
Time [s]
143

FIG 1C

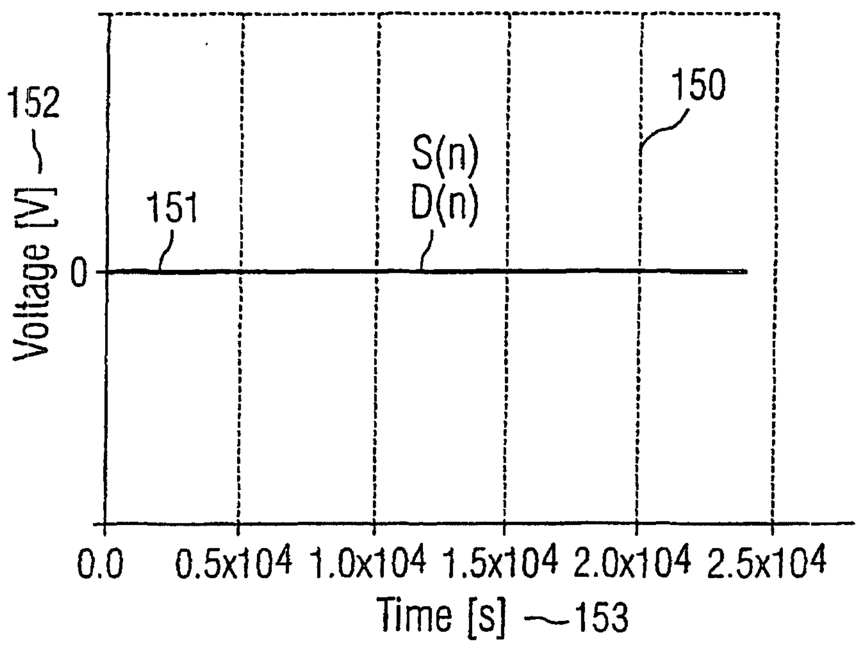
152
Voltage [V]
0
151
S(n)
D(n)
150
0.0
0.5x10^4
1.0x10^4
1.5x10^4
2.0x10^4
2.5x10^4
Time [s]
153

FIG 1D

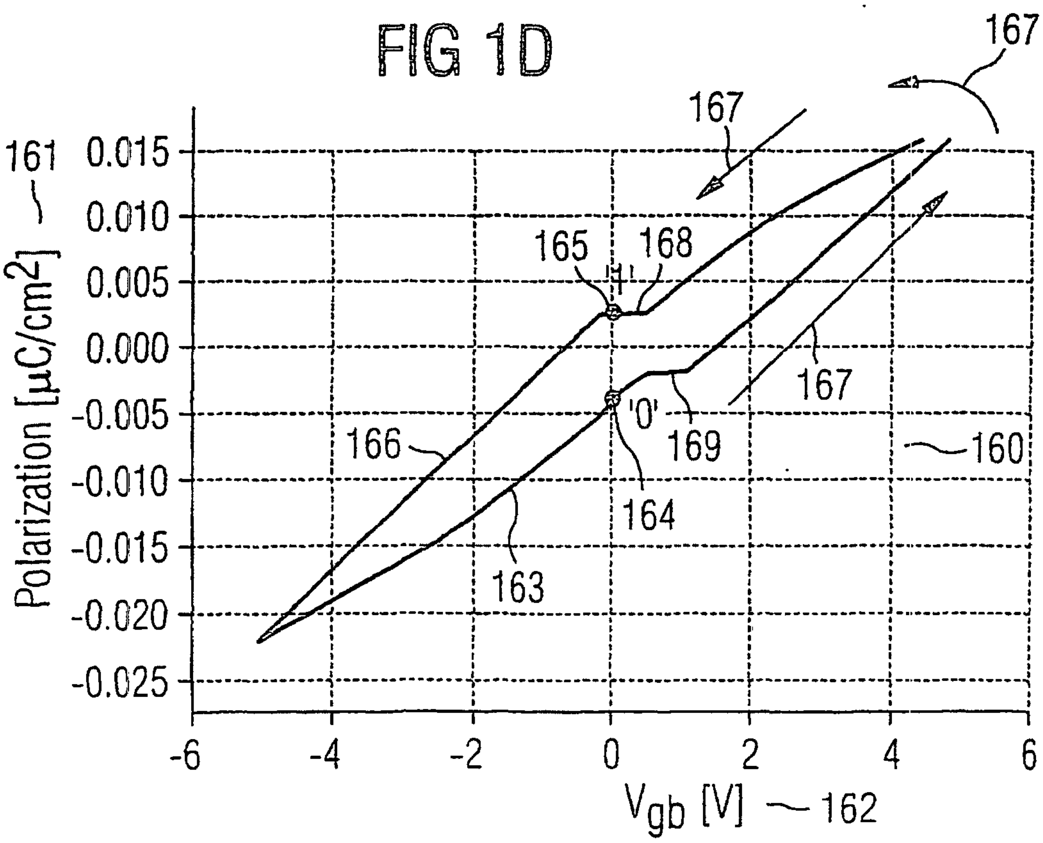
167
167
161
Polarization [μC/cm2]
0.015
0.010
0.005
0.000
-0.005
-0.010
-0.015
-0.020
-0.025
165
168
'1'
'0'
169
167
166
164
163
160
-6
-4
-2
0
2
4
6
Vgb [V]
162

FIG 2

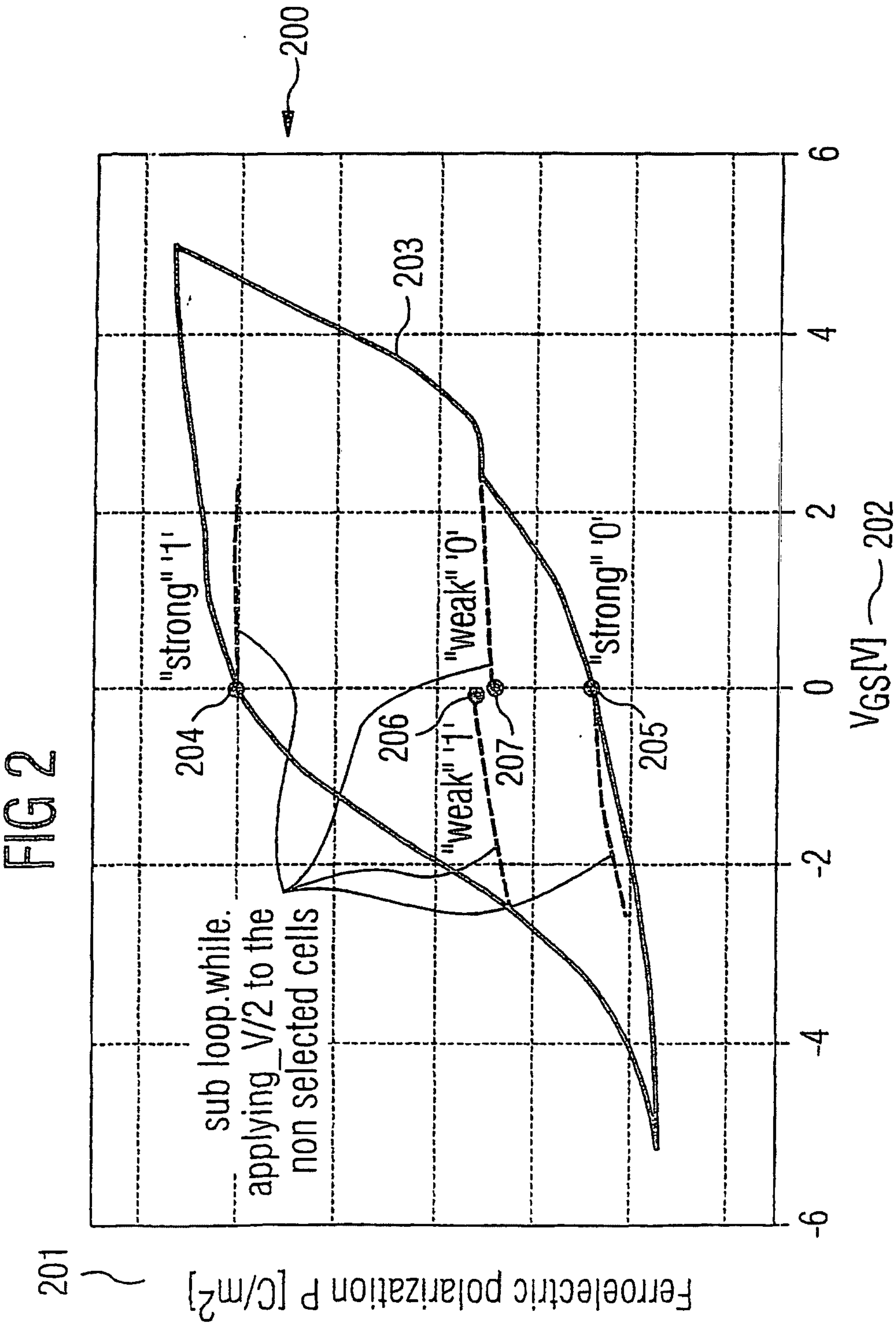
200
201
Ferroelectric polarization P [C/m2]
202
VGS[V]
203
204
205
206
207
"strong" '1'
"weak" '0'
"strong" '0'
"weak" '1'
sub loop.while.
applying_V/2 to the
non selected cells
-6
-4
-2
0
2
4
6

FIG 3

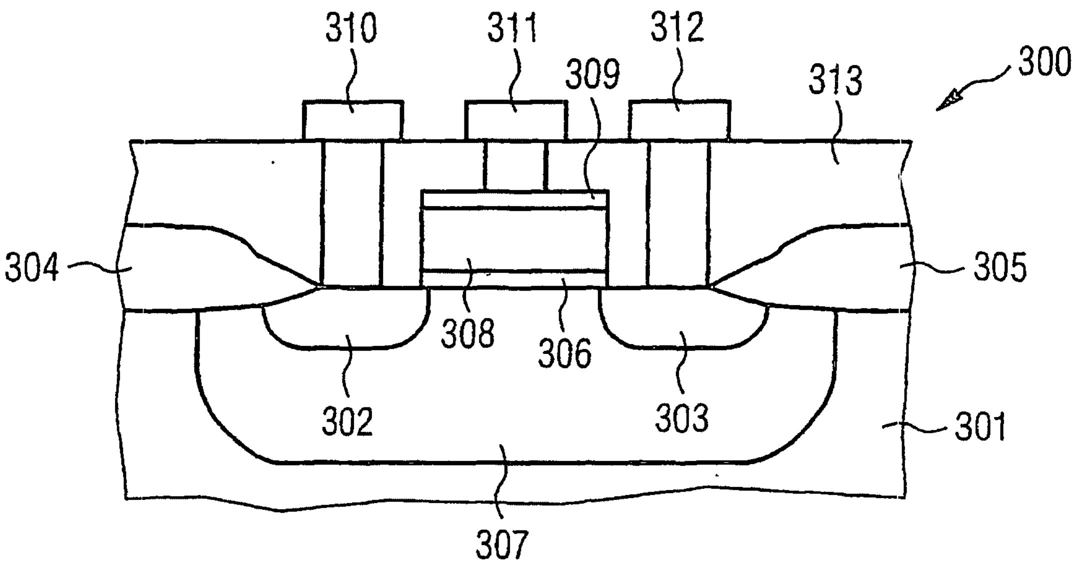
310
311
312
309
313
300
304
305
308
306
302
303
301
307

FIG 4

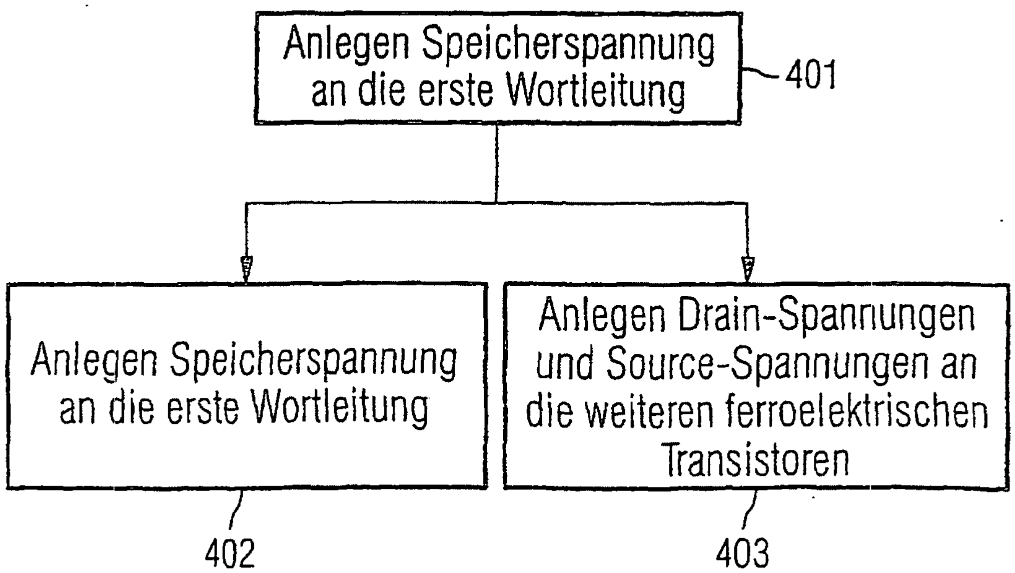
Anlegen Speicherspannung an die erste Wortleitung
401
Anlegen Speicherspannung an die erste Wortleitung
Anlegen Drain-Spannungen und Source-Spannungen an die weiteren ferroelektrischen Transistoren
402
403

FIG 5

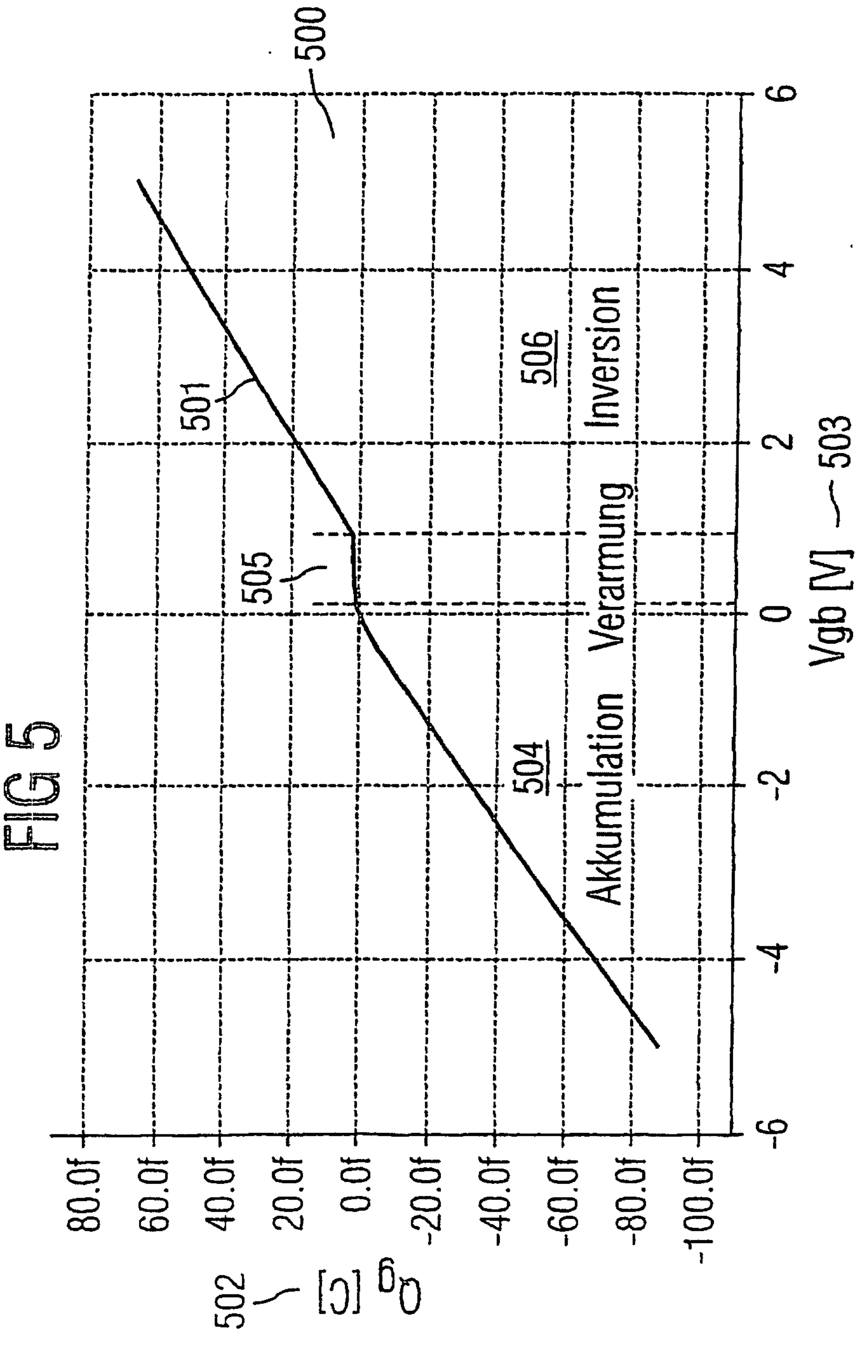
500
501
502
$Q_g$ [C]
80.0f
60.0f
40.0f
20.0f
0.0f
-20.0f
-40.0f
-60.0f
-80.0f
-100.0f
-6
-4
-2
0
2
4
6
Vgb [V]
503
504
Akkumulation
505
Verarmung
506
Inversion

FIG 6A

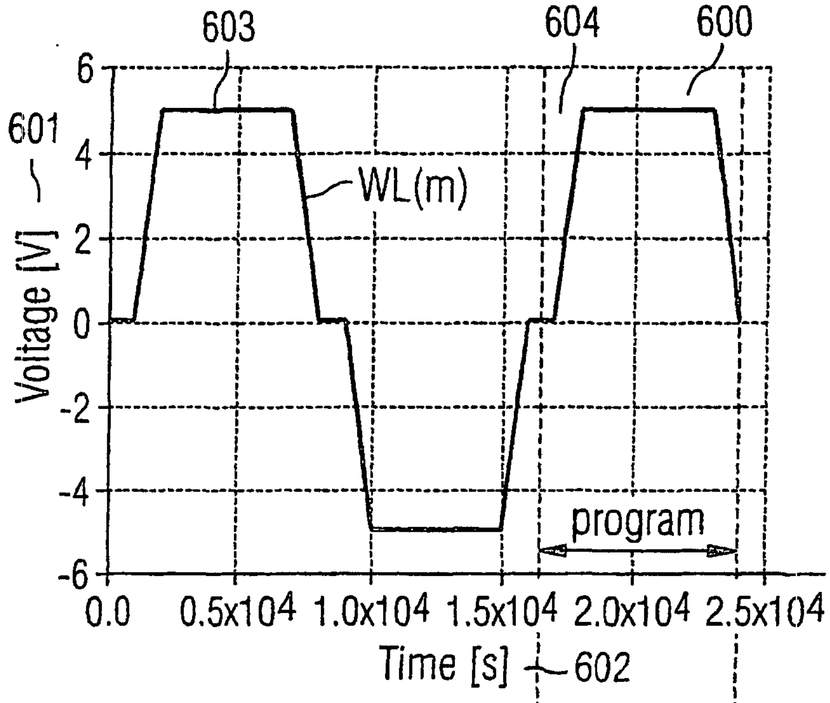
603
604
600
601
WL(m)
Voltage [V]
6
4
2
0
-2
-4
-6
program
0.0
0.5x10⁴
1.0x10⁴
1.5x10⁴
2.0x10⁴
2.5x10⁴
Time [s]
602

FIG 6B

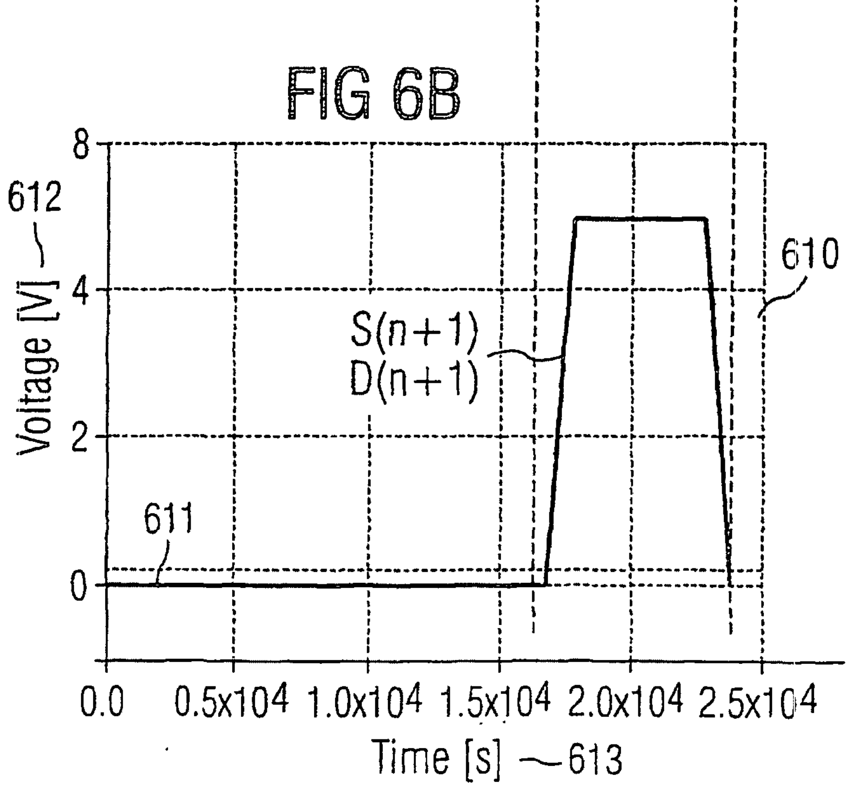
612
Voltage [V]
8
4
2
0
610
S(n+1)
D(n+1)
611
0.0
0.5x10⁴
1.0x10⁴
1.5x10⁴
2.0x10⁴
2.5x10⁴
Time [s]
613

FIG 6C

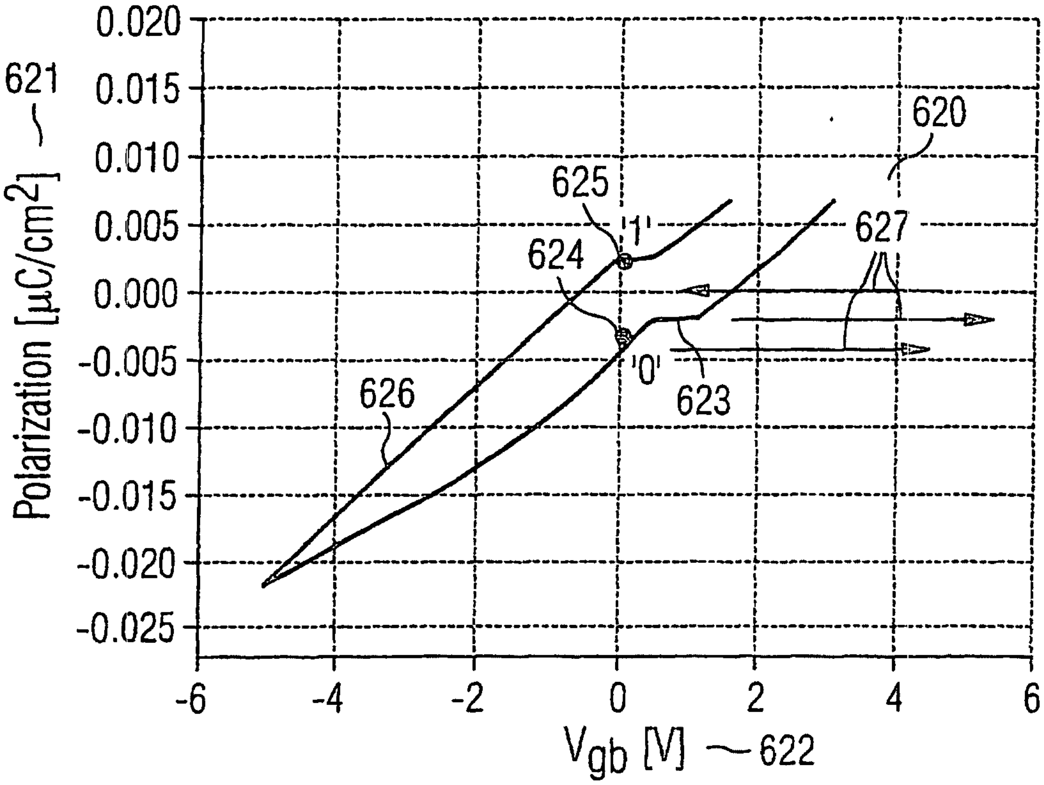

0.020
0.015
0.010
0.005
0.000
-0.005
-0.010
-0.015
-0.020
-0.025
621
Polarization [µC/cm2]
620
625
'1'
624
627
'0'
623
626
-6
-4
-2
0
2
4
6
Vgb [V]
622